(19) Europäisches Patentamt
European Patent Office
Office européen des brevets

(11) Veröffentlichungsnummer: **0 206 266**
**B1**

# (12) EUROPÄISCHE PATENTSCHRIFT

(45) Veröffentlichungstag der Patentschrift: **23.08.89**

(51) Int. Cl.⁴: **C07C 125/08,** C08K 5/16, H01M 4/60, H01M 4/10, H01L 31/02

(21) Anmeldenummer: **86108389.7**

(22) Anmeldetag: **19.06.86**

## (54) Radikalionensalze.

(30) Priorität: **21.06.85 DE 3522232**

(43) Veröffentlichungstag der Anmeldung: **30.12.86 Patentblatt 86/52**

(45) Bekanntmachung des Hinweises auf die Patenterteilung: **23.08.89 Patentblatt 89/34**

(84) Benannte Vertragsstaaten: **BE CH DE FR GB IT LI NL SE**

(56) Entgegenhaltungen: **DE-A- 3 437 814**

(73) Patentinhaber: **BASF Aktiengesellschaft, Carl-Bosch-Strasse 38, D-6700 Ludwigshafen(DE)**

(72) Erfinder: **Huenig, Siegfried, Dr., Mittlerer Neubergweg 16, D-8700 Wuerzburg(DE)**
Erfinder: **Aumueller, Alexander, Dr., Brechlochstrasse 9, D-6700 Ludwigshafen(DE)**
Erfinder: **Erk, Peter, Paul-Ehrlich-Strasse 14, D-8708 Gerbrunn(DE)**

**EP 0 206 266 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft neue Radikalionensalze auf der Basis von N,N-Dicyanchinondiiminen.

Radikalionensalze aus Tetracyanchinodimethanen und Kupfer oder Silber sind bekannt [Appl. Phys. Lett. 34, 405 (1979), J. Amer. Chem. Soc. 102, 3659 (1980), Chem. Skripta 17, 219 (1981)].

Gegenstand der Erfindung sind neue Radikalionensalze aus Biscyaniminen der Formel

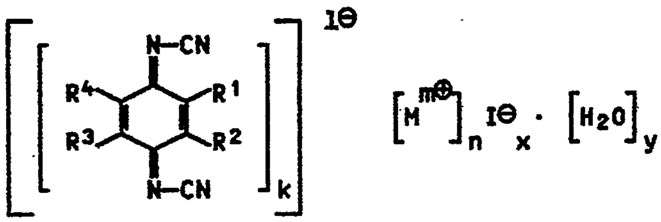
(I).

in der

$R^1$, $R^2$, $R^3$ und $R^4$ unabhängig voneinander für Wasserstoff, Methyl, Ethyl, Phenyl, Methoxy , Ethoxy, Fluor, Chlor oder Brom und wobei $R^1$ oder $R^1$ und $R^3$ auch tert.-Butyl und/oder $R^1$ und $R^2$ und/oder $R^3$ und $R^4$ jeweils zusammen einen Rest der Formel

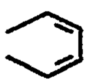 , 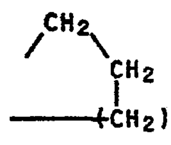 , 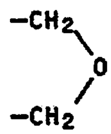 oder 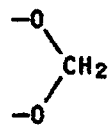

bedeuten, worin z 0, 1, 2 oder 3 ist und die ankondensierten, aromatischen Ringe gegebenenfalls durch 1 oder 2 Chlor, Brom, Methyl und/oder Methoxy substituiert sind, $M^{m\oplus}$ für ein m-wertiges Alkalimetall-, Erdalkalimetall-, Übergangsmetall-, Zinn-, Blei-, Thallium-, Ammonium-, Phosphonium-, Arsonium- oder Stiboniumion,

k für 1 bis 5,

l für 0,1 bis 4,

m für 1 bis 3,

n für 0,1 bis 4,

x für 0 bis 2 und

y für 0 bis 6 stehen, wobei k, l, n, x und y auch gebrochene Zahlen sein können und die Summe (l + x) = n•m ist.

Die erfindungsgemäßen Salze (I) (Komplexe) weisen im mikrokristallinen Zustand eine hohe elektrische Leitfähigkeit auf, die in Einkristallen in der Regel deutlich bis wesentlich höher liegt. So sind die Salze (I) den bekannten Radikalionensalzen auf der Basis Tetracyanochinodimethan und Kupfer oder Silber in der Leitfähigkeit deutlich überlegen. So hat das TCNQ•Cu-Salz des Standes der Technik eine Leitfähigkeit von 0,005 $S \cdot cm^{-1}$, [L.R. Melby et al J. Amer. Chem. Soc. 84, 3374 (1962)], das entsprechende erfindungsgemäße Radikalionensalz (= Beisp. 37) eine Leitfähigkeit von 0,02 $S \cdot cm^{-1}$. Eine Reihe der Verbindungen (I) ist thermostabil bei Temperaturen um und über 300°C. Dementsprechend sind die neuen Komplexe z.B. geeignet zur Verwendung als elektrische Halb- und Photoleiter, zur antistatischen Ausrüstung von Kunststoffen, als Elektroden- oder Speichermaterial in elektrischen Batterien, zur Herstellung von Solarzellen, in Brennstoffzellen, zur Umwandlung von Strahlung und zur Herstellung elektronischer Bauteile. Mikrokristalline Filme aus den erfindungsgemäßen Radikalionensalzen können zur Herstellung bistabiler elektrischer Schaltelemente verwendet werden.

Als Kombination von $R^1$, $R^2$, $R^3$ und $R^4$ sind im einzelnen z.B. zu nennen:

a) $R^1 = R^2 = R^3 = R^4$ = Wasserstoff, Fluor, Chlor, Methyl oder Methoxy oder

b) $R^1$ = Chlor, Brom, Methyl, Ethyl, Methoxy, Ethoxy, Phenyl oder tert.-Butyl und $R^2 = R^3 = R^4$ = Wasserstoff oder

c) $R^1 = R^4$ = Chlor, Methyl oder Methoxy und $R^2 = R^3$ = Wasserstoff oder

d) $R^1 = R^2$ = Chlor, Methyl, Methoxy oder Phenyl und $R^3 = R^4$ = Wasserstoff oder

e) $R^1 = R^3$ = Chlor, Brom, Methyl, Ethyl, Methoxy, Phenyl oder tert.-Butyl und $R^2 = R^4$ = Wasserstoff oder

f) $R^1 = R^2 = R^3$ = Methyl und $R^4$ = Wasserstoff oder

g) $R^1$ = Methyl, $R^3$ = Chlor oder Brom und $R^2 = R^4$ = Wasserstoff oder

h) $R^1$ und $R^2$ zusammen einen Rest der Formel

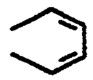 , 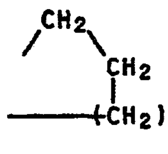 , 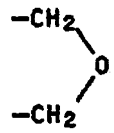 oder 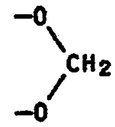

worin z 0, 1, 2 oder 3 ist und der ankondensierte aromatische Ring unsubstituiert oder durch 1 oder 2 Chlor, Methyl und/oder Methoxy substituiert ist, und $R^3$ und $R^4$ unabhängig voneinander Wasserstoff, Chlor oder Methyl oder

i) $R^1$ und $R^2$ sowie $R^3$ und $R^4$ jeweils zusammen einen Rest der Formel

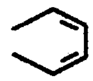 , 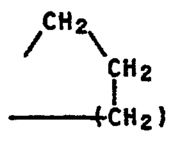 , 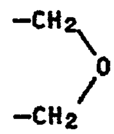 oder 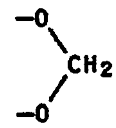

wobei z 0, 1, 2 oder 3 ist und die ankondensierten aromatischen Ringe unsubstituiert oder durch 1 oder 2 Chlor, Methyl und/oder Methoxy substituiert sind.

Als $M^{m\oplus}$ kommen in Betracht: Metallionen von Metallen, deren Redoxpotential ≤ dem des Silbers ist; Ammonium, Phosphonium, Arsonium und Stibonium.

Als Metallionen sind die der Alkalimetalle wie Lithium, Natrium, Kalium, Rubidium und Caesium, der Erdalkalimetalle wie Calcium, Strontium und Barium, der Übergangsmetalle wie Chrom, Mangan, Eisen, Cobalt, Nickel, Kupfer, Zink, Silber, Cadmium und Quecksilber sowie des Zinns, Bleis und Thalliums zu nennen.

Als Ammonium sind für $M^{m\oplus}$ z.B. zu nennen: Tetra-$C_1$- bis $C_4$-alkylammonium, Tetraphenyl-$C_1$- bis $C_3$-alkylammonium, Phenyl-$C_1$- bis $C_3$-alkyl-tris-$C_1$-bis $C_4$-alkylammonium, $C_1$- bis $C_4$-Alkyl-pyridinium, N-Phenyl-$C_1$- bis $C_3$-alkyl-pyridinium, Chinolinium, N-$C_1$- bis $C_4$-Alkylchinolinium, N-Phenyl-$C_1$- bis $C_3$-alkylchinolinium sowie die entsprechenden Isochinoliniumverbindungen, Phenazinium, N-$C_1$- bis $C_4$-Alkylphenazinium und N-Phenyl-$C_1$-bis $C_3$-alkyl-phenazinium.

Als Phosphonium-, Arsonium- und Stiboniumionen kommen vor allem solche in Betracht, die sich von den Triphenylverbindungen ableiten.

Als $M^{m\oplus}$ sind im einzelnen zu nennen: $Li^{\oplus}$, $Na^{\oplus}$, $K^{\oplus}$, $Rb^{\oplus}$, $Cs^{\oplus}$, $Mg^{2\oplus}$, $Ca^{2\oplus}$, $Ba^{2\oplus}$, $Sr^{2\oplus}$, $Cr^{3\oplus}$, $Mn^{2\oplus}$, $Fe^{2\oplus}$, $Fe^{3\oplus}$, $Co^{2\oplus}$, $Ni^{2\oplus}$, $Cu^{\oplus}$, $Cu^{2\oplus}$, $Zn^{2\oplus}$, $Ag^{\oplus}$, $Cd^{2\oplus}$, $Hg^{2\oplus}$, $Sn^{2\oplus}$, $Pb^{2\oplus}$, $Pb^{4\oplus}$, $Tl^{\oplus}$, $Tl^{3\oplus}$, Triphenylmethylphosphonium, Triphenylmethylarsonium, Triphenylmethylstibonium, Tetramethylammonium, Tetraethylammonium, Tetrapropylammonium, Tetrabutylammonium, Tetrabenzylammonium, Tetra(2-phenylethyl)-ammonium, Trimethylbenzylammonium, Triethylbenzylammonium, Pyridinium, N-Methyl- und N-Ethylpyridinium, N-Methyl-2-methylpyridinium, N-Methyl-3-methylpyridinium, N-Methyl-4-methylpyridinium, N-Benzylpyridinium, Chinolinium, N-Methyl-, N-Ethyl- und N-Benzylchinolinium, Phenazinium, N-Methyl-, N-Ethyl- und N-Benzylphenazinium.

Als $M^{m\oplus}$ sind bevorzugt: Kupfer-I- und Silber-I-ionen, Tetramethylammonium, Tetraethylammonium, Tetrabenzylammonium, Trimethylbenzylammonium, Triethylbenzylammonium, Chinolinium, Pyridinium, N-Methylpyridinium, N-Ethylchinolinium, N-Methylchinolinium, Phenazinium, N-Methylphenazinium; von diesen sind Kupfer-I-, Silber-I, Pyridinium, N-Methylpyridinium, Chinolinium, N-Methylchinolinium, Phenazinium und N-Methylphenazinium besonders bevorzugt.

Die erfindungsgemäßen Radikalionensalze (I) können nach verschiedenen Verfahrensvarianten hergestellt werden. Ein Weg ist die Umsetzung von N,N'-Dicyanchinondiiminen der Formel (II)

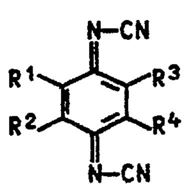 (II),

in der $R^1$, $R^2$ und $R^4$ die oben genannte Bedeutung haben, mit Halogeniden, vorzugsweise Iodiden der oben genannten Kationen $M^{m\oplus}$ im Molverhältnis 1:0,5 bis 1:3 in einem Lösungsmittel, gegebenenfalls in der Wärme. Als Lösungsmittel kommen beispielsweise Dichlormethan, Chloroform, Tetrahydrofuran, 1,1,1-Trichlorethan, Acetonitril, Benzol, Toluol, Chlorbenzol oder Dichlorbenzol in Frage. Die Radikalionensalze werden in üblicher Weise durch Absaugen isoliert.

Die Herstellung der erfindungsgemäßen Radikalionensalze (I) kann außerdem durch Reaktion von N,N'-Dicyanchinondiiminen der Formel (II) mit einem Metall M, vorzugsweise in pulverisierter Form im

Molverhältnis 1:1 bis 1:0,2 in einem der oben genannten, gegenüber dem Metall inerten Lösungsmittel, gegebenenfalls bei erhöhter Temperatur erfolgen. Die Radikalionensalze werden in üblicher Weise durch Absaugen isoliert.

Die erfindungsgemäßen Radikalionensalze (I) können weiterhin durch Elektrolyse einer Lösung, die ein N,N'-Dicyanchinondiimin der Formel (II) und ein Salz der oben genannten Kationen ($M^{m\oplus}$) in einem der oben genannten Lösungsmittel enthält, bei Temperaturen zwischen Raumtemperatur und -30°C hergestellt werden. Die Temperatur ist von der Löslichkeit des N,N'-Dicyanchinonimins abhängig. Vorzugsweise erfolgt die Elektrolyse bei Temperaturen < 0°C, insbesondere bei -10 bis -30°C, um evtl. Zersetzung möglichst zu vermeiden. Die Radikalionensalze werden auch hier in üblicher Weise durch Absaugen isoliert. Die Ausbeute an Radikalanionensalz (I) ist abhängig von der Dauer der Elektrolyse und von der Löslichkeit von (I) in dem bei der Elektrolyse verwendeten Lösungsmittel, da eine Isolierung des gelösten Salzes (I) aus der Leitsalze enthaltenden Elektrolyselösung sehr schwierig ist.

Die erfindungsgemäßen Radikalionensalze (I) können auch durch Umsetzen des Lithiumsalzes der N,N'-Dicyanchinondiimine der Formel (II) mit einem Salz der obengenannten Kationen ($M^{m\oplus}$) in einem Lösungsmittel wie Methanol, Ethanol, Propanol, Wasser, Acetonitril oder einem Gemisch dieser Lösungsmittel hergestellt werden.

Die Herstellung von mikrokristallinen Filmen, die aus den erfindungsgemäßen Radikalionensalzen bestehen, kann in an sich bekannter Weise durch Eintauchen eines metallischen Körpers in eine Lösung eines N,N'-Dicyanchinonimins in einer der oben genannten Lösungsmittel, vorzugsweise bei erhöhter Temperatur erfolgen.

Die Erfindung soll durch die folgenden Beispiele weiter erläutert werden. Prozentangaben bei den Ausbeuten stehen für Prozent der theoretischen Ausbeute. Die angegebenen Leitfähigkeiten wurden an Pulverpreßlingen oder an Einkristallen bestimmt.

Beispiel 1

Zu einer filtrierten Lösung von 1,34 g (= 10,0 ml) Lithiumiodid in Acetonitril tropft man unter Rühren eine Lösung von 156 mg (= 100 mmol) N,N'-Dicyan-1,4-benzochinondiimin. Nach 10 Min. Rühren saugt man ab und wäscht mit Acetonitril nach. Man isoliert 98 mg (52 %) des entsprechenden Radikalionensalzes in Form eines hellvioletten Pulvers, das sich ab 234°C zersetzt.

| | | | | | |
|---|---|---|---|---|---|
| Analyse: $C_8H_6I_{0,06}Li_{1,06}N_4O$ | Ber. | C 50,81 | H 3,20 | I 4,03 | N 29,64 % |
| | Gef. | C 51,43 | H 3,19 | I 3,93 | N 28,98 % |

Beispiele 2 bis 9

Zu einer Lösung des N,N'-Dicyanchinondiimins (II) in Acetonitril gibt man eine Lösung von Kupfer-I-iodid in Acetonitril. Dabei fällt ein dunkler Niederschlag aus, der abgesaugt und mit Acetonitril gewaschen wird. Die verwendeten N,N'-Dicyanchinondiimine (II) sind in der Tabelle 1 durch die Substituenten in den Spalten 2 bis 5 charakterisiert.

Die erhaltenen Radikalanionensalze haben die allgemeine Formel (Ia)

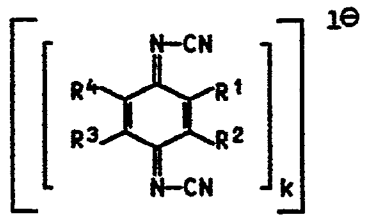 $Cu^{\oplus}_n \; I^{\ominus}_x \cdot [H_2O]_y$ (Ia).

Die Bedeutung von k, l, n, x und y ist in den Spalten 6 bis 10 der Tabelle 1 angegeben. In der Tabelle sind die Salze (Ia) durch den Zersetzungspunkt und die Elementaranalyse charakterisiert.

Tabelle 1

| Bsp. | $R^1$ | $R^2$ | $R^3$ | $R^4$ | k | l | n | x | y | Elementaranalyse C [%] | H [%] | N [%] | sonst. Elemente | Zers.-P. [°C] | Ausbeute [% d. Th.] | Leitfähigkeit σ [S · $cm^{-1}$] |
|---|---|---|---|---|---|---|---|---|---|---|---|---|---|---|---|---|
| 2 | H | H | H | H | 1 | 1 | 1 | 0 | 0 | 44,20 | 1,63 | 25,04 | Cu: 28,2 | ab 265 | 75 | |
| 3 | $CH_3$ | H | H | H | 1 | 1 | 1 | 0 | 0 | 45,81 | 2,69 | 23,45 | Cu: 25,2 | ab 205 | 60 | |
| 4 | $CH_3$ | $CH_3$ | H | H | 1,3 | 1 | 1 | 0 | 0 | 51,47 | 3,59 | 23,83 | | ab 205 | 51 | |
| 5 | $CH_3$ | H | $CH_3$ | H | 2 | 1 | 1 | 0 | 0 | 55,91 | 3,61 | 26,07 | | ab 229 | 87 | |
| 6 | $OCH_3$ | H | $OCH_3$ | H | 3 | 2 | 2 | 0 | 0 | 46,78 | 3,09 | 21,96 | | ab 280 | 78 | |
| 7 | Cl | H | Cl | H | 1,63 | 1 | 1 | 0 | 0 | 36,44 | 0,67 | 21,25 | | > 350 | 46 | 2,5 |
| 8 | $CH_3$ | $CH_3$ | $CH_3$ | H | 1,75 | 0,91 | 1 | 0,09 | 0 | 54,91 | 4,19 | 23,27 | I: 2,81 | ab 173 | 83 | $1,3 \cdot 10^{-2}$ |
| 9 | $-(CH=CH)_2-$ | | H | H | 1,10 | 0,4 | 2 | 1,6 | 0 | 28,26 | 0,92 | 11,21 | I: 36,78 | > 350 | 54 | 0,4 |
| 10 | Cl | H | $CH_3$ | H | 2 | 1 | 1 | 0 | 0 | 42,47 | 1,81 | 21,42 | | > 350 | 98 | |
| 11 | $-(CH=CH)_2-$ | | H | H | 5 | 4 | 4 | 0 | 0 | 55,23 | 3,82 | 21,40 | | > 350 | 78 | |

Beispiel 12

Man verfährt analog Beispiel 1, verwendet jedoch eine Lösung von Kupfer-I-bromid in Tetrahydrofuran und tropft dazu eine Lösung des 2-Chlor-5-methyl-N,N'-dicyan-1,4-benzochinondiimins. Man erhält in 93 % Ausbeute das entsprechende Radikalionensalz der Formel

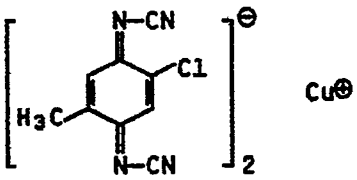

Schmp. > 350°C

$C_9H_5N_4Cl$ Cu  ber.: C 45,73  H 2,13  N 23,70 %

gef.: C 45,40  H 1,85  N 23,42 %

Leitfähigkeit: 0,4 S•cm⁻¹ (Pulver).

Beispiele 13 bis 15

N,N'-Dicyanchinondiimine (II) werden mit Silber-Pulver in Acetonitril bei Raumtemperatur gerührt. Der unlösliche Anteil wird abgesaugt. Die verwendeten N,N'-Dicyanchinondiimine (II) sind in der Tabelle 2 in den Spalten 2 bis 5 durch $R^1$ bis $R^4$ charakterisiert.

Die erhaltenen Radikalionensalze haben die allgemeine Formel (Ib)

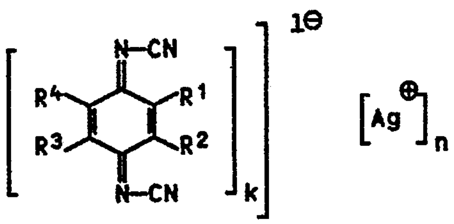

(Ib)

Die Bedeutung von k, n und y ist in den Spalten 6 bis 9 angegeben.

In der Tabelle 2 sind die Salze (Ib) durch den Zersetzungspunkt, die Elementaranalyse und die elektrische Leitfähigkeit charakterisiert.

Tabelle 2

| Bsp. | $R^1$ | $R^2$ | $R^3$ | $R^4$ | k | n | Elementaranalyse C [%] | H [%] | N [%] | Zers.-P. [°C] | Leitfähigkeit $\sigma$ [S · cm⁻¹] |
|---|---|---|---|---|---|---|---|---|---|---|---|
| 13 | H | H | H | H | 1 | 1 | 36,41 | 1,32 | 20,86 | >350 | $1{,}7 \cdot 10^{-2}$ |
| 14 | Cl | H | Cl | H | 1,1 | 1 | 30,05 | 0,36 | 16,93 | >350 | 19,8 |
| 15 | H | H | Cl | H | 1,62 | 1 | 32,95 | 0,69 | 19,22 | >350 | $8 \cdot 10^{-2}$ |

Beispiel 16

Die Elektrolyse erfolgte in einer 60 ml Flüssigkeit fassenden, durch zwei G4-Glasfritten in 3 Kammern geteilte Zelle. Jede Kammer kann unabhängig von den anderen unter Schutzgas gefüllt bzw. entleert werden.

Die Elektroden befinden sich in den äußeren Kammern. Durch die Dreiteilung wird verhindert, daß an der Anode gebildete Nebenprodukte in den Kathodenraum eindringen können.

Als Elektroden dienen zwei Platinbleche von 20 × 10 × 1 mm. Elektroden und Zelle wurden vor jeder Verwendung mit einer Mischung aus 35 % Wasserstoffperoxid und konz. Schwefelsäure gereinigt. Anschließend wurde mit Wasser gespült und dann die Zelle 1 Tag in destilliertem Wasser gewässert, um letzte Spuren Säure zu entfernen. Dann wurde die Zelle bei 120°C getrocknet.

Die Stromversorgung erfolgte mit einer Konstantstromquelle, deren Strom zwischen 0 und 250 µA geregelt werden kann.

Durch Einstellen der Zelle in ein temperierbares Bad kann die Elektrolyse bei definierten Temperaturen durchgeführt werden.

Zur Elektrolyse wird in alle drei Kammern der Zelle eine Lösung von 92 mg (= 500 µmol) N,N'-Dicyano-2,5-dimethyl-1,4-benzochinondiimin und 170 mg (= 1,00 mmol) Silbernitrat in 60 ml Acetonitril gegeben und bei Raumtemperatur mit einer Stromstärke von 3 µA elektrolysiert. An der Kathode wachsen bis zu 3 cm lange, dünne Kristallnadeln. Nach 80 h isoliert man 12 mg (10 %) Silbersalz in Form von tiefschwarzen Nadeln vom Schmp.: 205°C (Zers.).

Analyse (476,3): $C_{20}H_{16}AgN_8$ Ber. C 50,43 H 3,39 N 23,53 %
Gef. C 50,42 H 3,29 N 22,91 %

Die Lösungen werden nicht bis zum Ende elektrolysiert, um Überreduktion zu vermeiden.

Beispiel 17

Eine Lösung von 68 mg (= 302 µmol) N,N'-Dicyano-2,5-dichlor-1,4-benzochinondiimin und 368 mg (= 2,27 mmol) Tetramethylammoniumtetrafluorborat in Acetonitril wird bei -25°C mit einer Stromstärke von 50 µA elektrolysiert. Nach 40 h werden die an der Kathode abgeschiedenen schwarzen, metallisch glänzenden, bis 2 mm langen Nadeln gesammelt und mit Diethylether gewaschen. Man erhält 20 mg (25 %) Radikalsalz vom Schmp.: 220°C (Zers.).

Analyse (476,3): $C_{22}H_{16}AgN_9$ Ber. C 45,82 H 3,00 N 24,05 %
Gef. C 46,37 H 3,10 N 23,95 %

Beispiele 18 bis 36

Analog den Beispielen 15 und 16 wurden die in der Tabelle 3 durch $R^1$, $R^2$, $R^3$ und $R^4$ charakterisierten N,N'-Dicyanchinondiimine (II) zusammen mit Kationen $M^{m\oplus}$ enthaltenden Salze in Acetonitril elektrolysiert. Die Elektrolyse erfolgte bei Temperaturen zwischen Raumtemperatur (25°C) und -20 bis -25°C, je nach der Löslichkeit der verwendeten N,N'-Dicyanchinondiimine (II). Die Ausbeute an (I) ist von der Dauer der Elektrolyse und von der Löslichkeit des entstehenden (I) in Acetonitril abhängig. Eine Isolierung des gelösten (I) aus der bei der Elektrolyse anfallenden und Leitsalz enthaltenden Acetonitrillösung ist sehr schwierig.

Es wurden Radikalionensalze der allgemeinen Formel (Ic) erhalten.

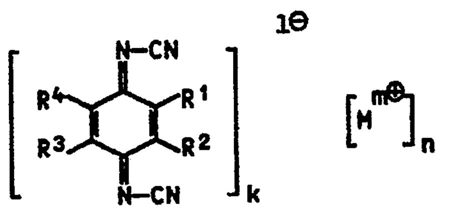

(Ic)

Die Bedeutung von k, $M^{m\oplus}$ und n ist in der Tabelle 3 (Spalten 6 bis 8) angegeben.

Die erhaltenen Salze (Ic) sind in den Spalten 9 bis 12 durch den Zersetzungspunkt und die Elementaranalyse und in einigen Fällen durch ihre Leitfähigkeit charakterisiert.

Tabelle 3

| Bsp. | $R^1$ | $R^2$ | $R^3$ | $R^4$ | $M^{m\oplus}$[1] | k | n | Elementaranalyse C [%] | H [%] | N [%] | Zers.-P. [°C] | Ausbeute [% d. Th.] | Leitfähigkeit σ [$S \cdot cm^{-1}$] |
|---|---|---|---|---|---|---|---|---|---|---|---|---|---|
| 18 | H | H | H | H | $Ag^{\oplus}$ | 1 | 1 | 36,41 | 1,38 | 21,04 | ab 270 | 8 | |
| 19 | $CH_3$ | $CH_3$ | H | H | $Ag^{\oplus}$ | 1 | 1 | 41,24 | 2,61 | 19,29 | ab 205 | 8 | |
| 20 | $CH_3$ | H | $CH_3$ | H | $Ag^{\oplus}$ | 2 | 1 | 50,42 | 3,29 | 22,91 | 205 | 10 | 18 |
| 21 | $CH_3$ | H | Cl | H | $Ag^{\oplus}$ | 2 | 1 | 41,41 | 1,88 | 21,41 | ab 207 | 38 | |
| 22 | Cl | H | Cl | H | $Ag^{\oplus}$ | 1,7 | 1 | 33,25 | 0,20 | 19,70 | ab 305 | 24 | |
| 23 | Br | H | Br | H | $Ag^{\oplus}$ | 3 | 2 | 25,03 | 1,06 | 14,35 | >350 | 15 | |
| 24 | Cl | H | Cl | H | $TMA^{\oplus}$ | 2 | 1 | 46,37 | 3,10 | 23,95 | ab 220 | 25 | $2 \cdot 10^{-2}$ |
| 25 | Br | H | Br | H | $TMA^{\oplus}$ | 3 | 2 | 35,82 | 2,89 | 17,43 | ab 205 | 6 | |
| 26 | Cl | H | Cl | H | $NMC^{\oplus}$ | 1,7 | 1 | 54,13 | 2,30 | 20,68 | ab 217 | 45 | 0,1 |
| 27 | Br | H | Br | H | $NMC^{\oplus}$ | 5 | 4 | 45,01 | 2,23 | 15,36 | 198 | 19 | |
| 28 | Br | H | Br | H | $NMC^{\oplus}$ | 3 | 2 | 42,67 | 2,02 | 16,09 | ab 218 | 43 | |
| 29 | Cl | H | Cl | H | $C^{\oplus}$ | 1 | 1 | 57,16 | 2,81 | 20,11 | ab 126 | 25 | |
| 30 | H | H | H | H | $NMP^{\oplus}$ | 2 | 1 | 68,53 | 3,89 | 27,25 | 125 | 8 | |
| 31 | Cl | H | Cl | H | $NMP^{\oplus}$ | 1 | 1 | 60,67 | 3,09 | 19,83 | 149 | 26 | |
| 32 | Br | H | Br | H | $NMP^{\oplus}$ | 1 | 1 | 47,10 | 2,47 | 15,85 | ab 121 | 7 | |
| 33 | $CH_3$ | H | Br | H | $Ag^{\oplus}$ | 2 | 1 | 35,85 | 1,68 | 18,94 | >350 | 45 | |
| 34 | $-(CH_2)_4-$ | | H | H | $Cu^{\oplus}$ | 5 | 4 | 55,11 | 3,73 | 21,84 | >350 | 58 | |
| 35 | Cl | H | Cl | H | $Cu^{\oplus}$ | 1 | 1 | 32,59 | 0,73 | 18,83 | >350 | 22 | 0,08[2] |
| 36 | $-(CH{=}CH)_2-$ | | Cl | Cl | $Ag^{\oplus}$ | 1 | 1 | 36,89 | 1,02 | 14,21 | >350 | 38 | 0,02[2] |
| 37 | $OCH_3$ | H | $OCH_3$ | H | $Cu^{\oplus}$ | 1 | 1 | 44,35 | 3,10 | 20,43 | >350 | 22 | 0,07[2] |
| 38 | H | H | H | H | $Cu^{\oplus}$ | 1 | 1 | 43,24 | 1,85 | 25,59 | >270 | 52 | 0,02[2] |
| 39 | $CH_3$ | H | Cl | H | $Cu^{\oplus}$ | 2 | 1 | 41,81 | 1,95 | 21,67 | >350 | 46 | 300[2][3]<br>0,4 |
| 40 | $CH_3$ | H | Br | H | $Cu^{\oplus}$ | 2 | 1 | 37,88 | 1,80 | 19,72 | >350 | 86 | 0,3[2] |

1) $TMA^{\oplus}$ = Tetramethylammonium, $NMC^{\oplus}$ = N-Methylchinolinium, $C^{\oplus}$ = Chinolinium, $NMP^{\oplus}$ = N-Methylphenazinium

2) gemessen am mikrokristallinen Pulver

3) gemessen am Einkristall

## Patentansprüche

1. Radikalionensalze der Formel

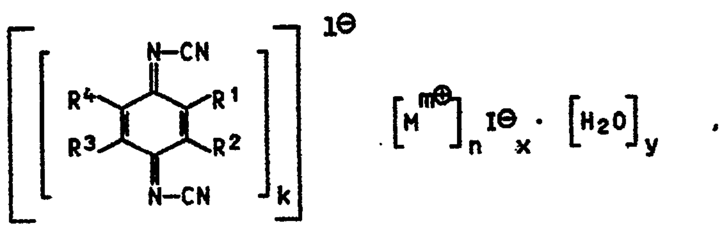

in der
$R^1$, $R^2$, $R^3$ und $R^4$ unabhängig voneinander für Wasserstoff, Methyl, Ethyl, Phenyl, Methoxy, Ethoxy, Fluor, Chlor oder Brom und wobei $R^1$ oder $R^1$ und $R^3$ auch tert.-Butyl und/oder $R^1$ und $R^2$ und/oder $R^3$ und $R^4$ jeweils zusammen einen Rest der Formel

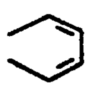 , 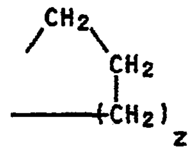 , 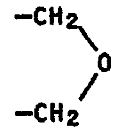 oder 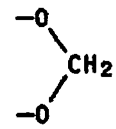

bedeuten und worin z 0, 1, 2 oder 3 ist und worin die ankondensierten aromatischen Ringe gegebenenfalls durch 1 oder 2 Chlor, Brom, Methyl und/oder Methoxy substituiert sind, $M^{m\oplus}$ für ein m-wertiges Alkalimetall-, Erdalkalimetall-, Übergangsmetall-, Zinn-, Blei-, Thallium-, Ammonium-, Phosphonium-, Arsonium- oder Stiboniumion,
k für 1 bis 5,
l für 0,1 bis 4,
m für 1 bis 3,
n für 0,1 bis 4,
x für 0 bis 2 und
y für 0 bis 6 stehen, wobei k, l, n, x und y auch gebrochene Zahlen sein können und die Summe (l + x) = n•m ist.

2. Radikalanionensalze gemäß Anspruch 1, dadurch gekennzeichnet, daß $M^{m\oplus}$ für Tetra-$C_1$- bis $C_4$-alkylammonium, Tetraphenyl-$C_1$- bis $C_3$-alkylammonium, Phenyl-$C_1$-bis $C_3$-alkyl-tris-$C_1$-bis $C_4$-alkylammonium, $C_1$-bis $C_4$-Alkyl-pyridinium, N-(Phenyl-$C_1$- bis $C_3$-alkyl)pyridinium, Chinolinium, N-$C_1$- bis $C_4$-Alkylchinolinium, N-(Phenyl-$C_1$- bis $C_3$-alkyl)-chinolinium, Isochinolinium, N-$C_1$-bis $C_4$-Alkylisochinolinium, N-(Phenyl-$C_1$-bis $C_3$-alkyl)-isochinolinium, Phenazinium, N-$C_1$-bis $C_4$-Alkylphenazinium oder N-(Phenyl-$C_1$- bis $C_3$-alkyl)-phenazinium steht.

3. Radikalionensalze gemäß Anspruch 1, dadurch gekennzeichnet, daß $M^{m\oplus}$ für ein Kupfer-I- oder Silberion oder für Tetramethylammonium, Tetraethylammonium, Tetrabenzylammonium, Trimethylbenzylammonium, Triethylbenzylammonium, Chinolinium, Pyridinium, N-Methylpyridinium, N-Ethylchinolinium, N-Methylchinolinium, Phenazinium oder N-Methylphenazinium steht.

4. Radikalionensalze der Formel gemäß Anspruch 1, dadurch gekennzeichnet, daß $M^{m\oplus}$ für ein Kupfer-I- oder Silberion oder für Pyridinium, N-Methylpyridinium, Chinolinium, N-Methylchinolinium, Phenazinium- oder N-Methylphenaziniumion steht.

5. Radikalionensalze gemäß Anspruch 1, 2, 3 oder 4, dadurch gekennzeichnet, daß in der Formel $R^1$, $R^2$, $R^3$ und $R^4$ jeweils für Wasserstoff, Fluor, Chlor, Methyl oder Methoxy oder $R^1$ für Chlor, Brom, Methyl, Ethyl, Methoxy, Ethoxy, Phenyl oder tert.-Butyl und $R^2$, $R^3$ und $R^4$ für Wasserstoff stehen.

6. Radikalionensalze gemäß Anspruch 1, 2, 3 oder 4, dadurch gekennzeichnet, daß $R^1$ und $R^4$ für Chlor, Methyl oder Methoxy und $R^2$ und $R^3$ für Wasserstoff oder $R^1$ und $R^2$ für Chlor, Methyl, Methoxy oder Phenyl und $R^3$ und $R^4$ für Wasserstoff oder $R^1$ und $R^3$ für Chlor, Brom, Methyl, Ethyl, Methoxy, Phenyl oder tert.Butyl und $R^2$ und $R^4$ für Wasserstoff stehen.

7. Radikalionensalze gemäß Anspruch 1, 2, 3 oder 4, dadurch gekennzeichnet, daß $R^1$, $R^2$ und $R^3$ für Methyl und $R^4$ für Wasserstoff oder $R^1$ für Methyl, $R^3$ für Chlor oder Brom und $R^2$ und $R^4$ für Wasserstoff stehen.

8. Radikalionensalze gemäß Anspruch 1, 2, 3 oder 4, dadurch gekennzeichnet, daß $R^1$ und $R^2$ zusammen einen Rest der Formel

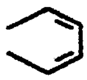 , 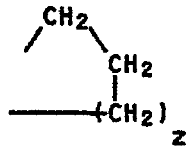 , 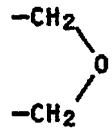 oder 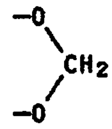

bedeuten, worin z 1 oder 2 ist und wobei der ankondensierte aromatische Ring unsubstituiert oder durch Chlor, Methyl und/oder Methoxy mono- oder disubstituiert ist und $R^3$ und $R^4$ unabhängig voneinander Wasserstoff, Chlor oder Methyl bedeuten.

9. Verwendung der Radikalionensalze gemäß den Ansprüchen 1 bis 8 zur antistatischen Ausrüstung von Kunststoffen, als Elektroden- oder Speichermaterial in elektrischen Batterien, zur Herstellung von Solarzellen, in Brennstoffzellen, zur Umwandlung von Strahlung oder zur Herstellung elektronischer Bauteile.

## Claims

1. A radical ion salt of the formula

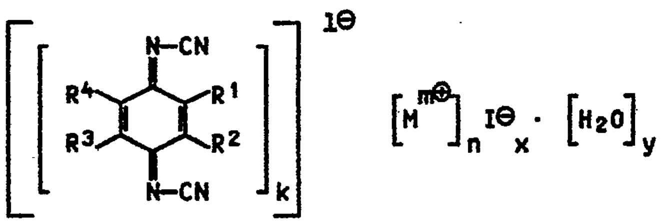 (I).

where $R^1$, $R^2$, $R^3$ and $R^4$ independently of one another are each hydrogen, methyl, ethyl, phenyl, methoxy, ethoxy, fluorine, chlorine or bromine and $R^1$ or $R^1$ and $R^3$ are furthermore tert-butyl, and/or $R^1$ and $R^2$ and/or $R^3$ and $R^4$ together in each case form a radical of the formula

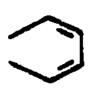 , 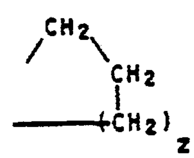 , 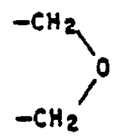 or 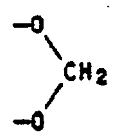

where z is 0, 1, 2 or 3, and where the fused-on aromatic rings are unsubstituted or monosubstituted or disubstituted by chlorine, bromine, methyl and/or methoxy, $M^{m\oplus}$ is an m-valent alkali metal, alkaline earth metal, transition metal, tin, lead, thallium, ammonium, phosphonium, arsonium or stibonium ion, k is from 1 to 5, l is from 0.1 to 4, m is from 1 to 3, n is from 0.1 to 4, x is from 0 to 2 and y is from 0 to 6, and k, l, n, x and y may further-more be non-integral numbers and $(l + x) = n.m$.

2. A radical ion salt as claimed in claim 1, wherein $M^{m\oplus}$ is tetra-$C_1$–$C_4$-alkylammonium, tetraphenyl-$C_1$–$C_3$-alkylammonium, phenyl-$C_1$–$C_3$-alkyl-tris-$C_1$–$C_4$-alkylammonium, $C_1$–$C_4$-alkylpyridinium, N-(phenyl-$C_1$–$C_3$-alkyl)-pyridinium, quinolinium, N-$C_1$–$C_4$-alkylquinolinium, N-(phenyl-$C_1$–$C_3$-alkyl)-quinolinium, isoquinolinium, N-$C_1$–$C_4$-alkyl-isoquinolinium, N-(phenyl-$C_1$–$C_3$-alkyl)-isoquinolinium, phenazinium, N-$C_1$–$C_4$-alkylphenazinium or N-(phenyl-$C_1$–$C_3$-alkyl)-phenazinium.

3. A radical ion salt as claimed in claim 1, wherein $M^{m\oplus}$ is a copper(I) or silver ion or tetramethylammonium, tetraethylammonium, tetrabenzylammonium, trimethylbenzylammonium, triethylbenzylammonium, quinolinium, pyridinium, N-methylpyridinium, N-ethylquinolinium, N-methylquinolinium, phenazinium or N-methylphenazinium.

4. A radical ion salt of the formula according to claim 1, wherein $M^{m\oplus}$ is a copper(I) or silver ion or pyridinium, N-methylpyridinium, quinolinium, N-methylquinolinium, phenazinium or N-methylphenazinium.

5. A radical ion salt as claimed in any of claims 1, 2, 3 or 4, wherein in the formula $R^1$, $R^2$, $R^3$ and $R^4$ are each hydrogen, fluorine, chlorine, methyl or methoxy or $R^1$ is chlorine, bromine, methyl, ethyl, methoxy, ethoxy, phenyl or tert-butyl and $R^2$, $R^3$ and $R^4$ are each hydrogen.

6. A radical ion salt as claimed in any of claims 1, 2, 3 or 4, wherein $R^1$ and $R^4$ are each chlorine, methyl or methoxy and $R^2$ and $R^3$ are each hydrogen, or $R^1$ and $R^2$ are each chlorine, methyl, methoxy or phenyl and $R^3$ and $R^4$ are each hydrogen, or $R^1$ and $R^3$ are each chlorine, bromine, methyl, ethyl, methoxy, phenyl or tert-butyl and $R^2$ and $R^4$ are each hydrogen.

7. A radical ion salt as claimed in any of claims 1, 2, 3 or 4, wherein $R^1$, $R^2$ and $R^3$ are each methyl and $R^4$ is hydrogen, or $R^1$ is methyl, $R^3$ is chlorine or bromine and $R^2$ and $R^4$ are each hydrogen.

8. A radical ion salt as claimed in any of claims 1, 2, 3 or 4, wherein $R^1$ and $R^2$ together form a radical of the formula

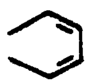 , 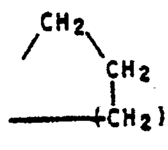 , 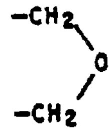 or 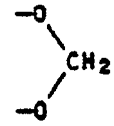

where z is 1 or 2, and the fused-on aromatic ring is unsubstituted or monosubstituted or disubstituted by chlorine, methyl and/or methoxy, and $R^3$ and $R^4$ independently of one another are each hydrogen, chlorine or methyl.

9. Use of a radical ion salt as claimed in any of claims 1 to 8 as antistats in plastics, as electrode and storage material in electric batteries, for the production of solar cells, in fuel cells, for the conversion of radiation or for the production of electronic components.

**Revendications**

1. Sels d'ions radicalaires de formule

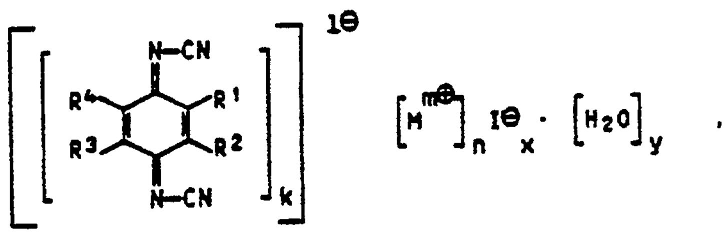

dans laquelle

$R^1$, $R^2$, $R^3$ et $R^4$ représentent indépendamment les uns des autres un atome d'hydrogène, un groupement méthyle, éthyle, phényle, méthoxy, éthoxy, un atome de fluor, de chlore ou de brome, $R^1$ ou $R^1$ et $R^3$ pouvant également être un groupement tert.-butyle et/ou $R^1$ et $R^2$ et/ou $R^3$ et $R^4$ pouvant chacun représenter ensemble un reste de formule

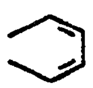 , 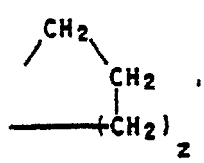 , 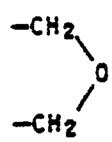 ou 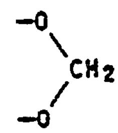

où z est 0,1, 2 ou 3 et les noyaux aromatiques condensés sont éventuellement substitués par 1 ou 2 atomes de chlore ou de brome ou groupements méthyle et/ou méthoxy.

$M^{m\oplus}$ représente un ion de valence m de métal alcalin, de metal alcalinoterreux, de métal de transition, de zinc, de plomb, de thallium, ammonium, phosphonium, arsonium ou antimonium,
k est mis pour 1 à 5,
l est mis pour 0,1 à 4,
m est mis pour 1 à 3,
n est mis pour 0,1 à 4,
x est mis pour 0 à 2 et
y est mis pour 0 à 6, k, l, n, x et y pouvant également être des nombres fractionnaires et la somme $(1 + x) = n.m$.

2. Sels d'ions radicalaires selon la revendication 1, caractérisés en ce que $M^{m\oplus}$ représente un ion tétra(alkyl en $C_1$–$C_4$) ammonium, tétraphényl-(alkyl en $C_1$–$C_3$) ammonium, phényl-(alkyl en $C_1$–$C_3$) -tris-(alkyl en $C_1$–$C_4$) ammonium, (alkyl en $C_1$–$C_4$) pyridinium, N-[phényl-(alkyl en $C_1$–$C_3$)] pyridinium, quinolinium, N-(alkyl en $C_1$–$C_4$) quinolinium, N-[phényl-(alkyl en $C_1$–$C_3$)] quinolinium, isoquinolinium, N-(alkyl en $C_1$–$C_4$) isoquinolinium, N-[phényl-(alkyl en $C_1$–$C_3$)] isoquinolinium, phénazinium, N-(alkyl en $C_1$–$C_4$) phénazinium ou N-[phényl-(alkyl en $C_1$–$C_3$)] phénazinium.

3. Sels d'ions radicalaires selon la revendication 1, caractérisés en ce que $M^{m\oplus}$ est mis pour un ion cuivre–I ou argent ou pour un ion tétraméthylammonium, tétraéthylammonium, tétrabenzylammonium, triméthylbenzylammonium, triéthylbenzylammonium, quinolinium, pyridinium, N-méthylpyridinium, N-éthylquinolinium, N-méthylquinolinium, phénazinium ou N-méthylphénazinium.

4. Sels d'ions radicalaires ayant la formule selon la revendication 1, caractérisés en ce que $M^{m\oplus}$ est mis pour un ion cuivre–I ou argent ou pour un ion pyridinium, N-méthylpyridinium, quinolinium, N-méthylquinolinium, phénazinium ou N-méthylphénazinium.

5. Sels d'ions radicalaires selon la revendication 1, 2, 3 ou 4, caractérisés en ce que dans la formule; $R^1$, $R^2$, $R^3$ et $R^4$ sont chacun mis pour un atome d'hydrogene, de fluor ou de chlore ou un groupement méthyle ou methoxy, ou bien $R^1$ est mis pour un atome de chlore ou de brome ou pour un groupement méthyle, éthyle, méthoxy, éthoxy, phényle ou tert.-butyle et $R^2$, $R^3$ et $R^4$ sont mis pour un atome d'hydrogène.

6. Ions de sels radicalaires selon la revendication 1, 2, 3 ou 4, caractérisés en ce que $R^1$ et $R^4$ sont mis pour un atome de chlore ou un groupement méthyle ou méthoxy et $R^2$ et $R^3$ sont mis pour un atome d'hydrogène ou bien $R^1$ et $R^2$ sont mis pour un atome de chlore ou un groupement méthyle, méthoxy ou phényle et $R^3$ et $R^4$ sont mis pour un atome d'hydrogène ou bien $R^1$ et $R^3$ sont mis pour un atome de chlore ou de brome ou un groupement méthyle, éthyle, méthoxy, phényle ou tert.-butyle et $R^2$ et $R^4$ sont mis pour un atome d'hydrogène.

7. Ions de sels radicalaires selon la revendication 1, 2, 3 ou 4, caractérisés en ce que $R^1$, $R^2$ et $R^3$ sont mis pour des groupements méthyle et $R^4$ est mis pour un atome d'hydrogène ou bien $R^1$ est mis pour un groupement méthyle, $R^3$ pour un atome de chlore ou de brome et $R^2$ et $R^4$ pour des atomes d'hydrogène.

8. Sels d'ions radicalaires selon la revendication 1, 2, 3 ou 4, caractérisés en ce que $R^1$ et $R^2$ représentent ensemble un reste de formule

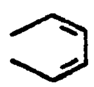 , 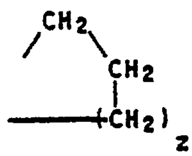 , 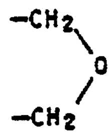 ou 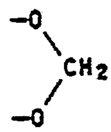

où z est 1 ou 2 et où le noyau aromatique condensé est non substitué ou est mono-ou disubstitué par des radicaux chloro, méthyle et/ou méthoxy et $R^3$ et $R^4$ représentent indépendamment l'un de l'autre un atome d'hydrogène ou de chlore ou un groupement méthyle.

9. Utilisation des sels d'ions radicalaires selon l'une quelconque des revendications 1 à 8, pour le traitement antistatique de matières plastiques, comme électrodes ou matériaux d'accumulation dans des accumulateurs électriques, pour la fabrication de cellules solaires, dans des cellules électrochimiques, pour la transformation de rayonnement ou pour la préparation de composants électroniques.